# EUROPÄISCHE PATENTSCHRIFT

(11) **EP 1 811 364 B1**
(45) Veröffentlichungstag und Bekanntmachung des Hinweises auf die Patenterteilung: **05.04.2017**
(21) Anmeldenummer: 06124736.7
(22) Anmeldetag: 24.11.2006
(51) Int. Cl.: G06F 3/045, G06F 3/044, H03K 17/96

(54) **Anzeigevorrichtung mit Berührung sensitiver Oberfläche**
Display device with touch sensitive surface
Dispositif d'affichage avec une surface sensible au toucher

(30) Priorität: 03.01.2006 DE 102006000637
(43) Veröffentlichungstag der Anmeldung: 25.07.2007
(73) Patentinhaber: ROBERT BOSCH GMBH, 70442 Stuttgart (DE)
(72) Erfinder: Czaya, Claus-Peter, 31141 Hildesheim (DE); Reinhard, Oliver, 80992 München (DE); Koss, Sebastian, 30167 Hannover (DE)

(56) Entgegenhaltungen:
- WO-A1-02/35461
- GB-A- 2 288 665
- US-A1- 2001 013 855
- US-A1- 2005 140 660

## Beschreibung

Die Erfindung betrifft eine Anzeigevorrichtung mit berührungsloser sensitiver Oberfläche nach dem Oberbegriff des Anspruchs 1.

### Stand der Technik

Es sind verschiedene Ausführungsformen von Anzeigevorrichtungen mit berührungsloser sensitiver Oberfläche, so genannte "Touchpanels" bekannt. In der Regel arbeiten die Touchpanels mit resistiven oder kapazitiven Sensoren, das heißt eine Schichtanordnung des Touchpanels kann kapazitiv, resistiv, optisch oder mittels Oberflächenwellen ausgewertet werden.

Solche alternativ verwendeten Auswertetechniken sind aus der EP 1 569 079 A1 bekannt.

### Offenbarung der Erfindung

Der Erfindung liegt die Aufgabe zugrunde, eine berührungssensitive Anzeigevorrichtung mit einem erweiterten Einsatzbereich bereit zu stellen.

Diese Aufgabe wird durch die Merkmale des Anspruchs 1 gelöst.

In den abhängigen Ansprüchen sind vorteilhafte und zweckmäßige Weiterbildungen der Erfindung angegeben.

Aus der GB 2 288 665 A ist eine Informations-Eingabeeinheit bekannt, bei der eine touch-panel- und digitizer-Funktionalität dargestellt wird.

Aus der US 2001/0013855 A1 ist ein touchpad mit einem resistiven und einem kapazitiven Sensor bekannt.

Aus der WO 02/35461 A1 ist ein Touchscreen bekannt, bei dem eine Berührung durch kapazitive Elektroden erfasst und durch Kraftsensoren bestätigt wird.

Aus der US 2005/0140660 A1 ist ein Verfahren zur Darstellung auf einem Touchscreen bekannt, gemäß dem bei einer ersten erfassten Berührung ein Zoom eines Eingabebereichs erfolgt und bei einer anschließenden, erneuten erfassten Berührung in dem Eingabebereich eine Taste ausgewählt wird.

Die Erfindung geht von einer Anzeigevorrichtung mit berührungssensibler Oberfläche aus, die ein Schichtsystem zur Bestimmung der Position eines die Oberfläche der Anzeigevorrichtung berührenden oder kurz vor der Berührung stehenden Objekts, zum Beispiel eines Fingers umfasst. Der Kern der Erfindung liegt nun darin, dass das Schichtsystem sowohl eine kapazitive als auch resistive Auswertbarkeit erlaubt. Damit kann unterschieden werden, ob die Anzeigevorrichtung nur berührt oder gerade noch nicht berührt bzw. gedrückt wird. Mit der kapazitiven Schichtanordnung kann zum Beispiel die Position eines berührenden oder kurz vor der Berührung stehenden Objekts bestimmt werden, wogegen mit der resistiv auswertbaren Schichtanordnung festgestellt werden kann, ob das Objekt, zum Beispiel ein Finger oder ein Griffel auf und gegebenenfalls wie stark auf das Panel drückt. Die Kombination einer kapazitiv und resistiv auswertbaren Schichtanordnung zeigt im Vergleich zum Stand der Technik überraschende Vorteile. Der Vorteil gegenüber Panels auf der Basis von Oberflächenfiltern ist, dass sich der erfindungsgemäße Aufbau in beliebiger, insbesondere kleiner Größe herstellen lässt. Zu einer Kombination von optischen und resistiven Sensorschichten hat der erfindungsgemäße Aufbau den Vorteil einer kleineren Einbauhöhe.

Der erfindungsgemäße Aufbau hat außerdem den Vorteil, dass auf bewährte Techniken zu resistiven und kapazitiven berührungssensiblen Anzeigevorrichtungen zurückgegriffen werden kann.

In einer bevorzugten Ausführungsform der Erfindung liegt eine kapazitiv auswertbare Schichtanordnung über einer resistiv auswertbaren Schichtanordnung.

Vorzugsweise weist sowohl die kapazitive als auch die resistive Schichtanordnung eine flexible Isolatorschicht auf. Auf diese Weise kann der Druck eines Objekts, zum Beispiel eines Griffels oder Fingers durch die kapazitive Schichtanordnung auf die resistive Schichtanordnung weitergeleitet werden. In der resistiven Schichtanordnung bewirkt die Verformung des flexiblen Isolators eine Änderung des Widerstands zwischen zwei leitenden Ebenen, aus welcher die Druckkraft herleitbar ist.

Je nach Aufbau des Bereichs zwischen zwei leitenden Schichten des resistiv auswertbaren Schichtaufbaus, ist es grundsätzlich möglich eine Vielzahl von Drücken zu unterscheiden.

Vorzugsweise ist die resistiv arbeitende Schichtanordnung so aufgebaut, dass mindestens zwischen zwei verschieden starken Drücken unterschieden werden kann.

Um einen besonders einfachen Aufbau zu erhalten, ist es überdies bevorzugt, wenn die kapazitiv und resistiv auswertbare Schichtanordnung gemeinsam eine leitende Schicht nutzen. Beispielsweise kann statt einer gesonderten kapazitiven "Elektrodenschicht" zum Beispiel die obere leitende Schicht der resistiv auswertbaren Schichtanordnung für eine kapazitive Auswertung ausgebildet sein. Durch diese Maßnahme lassen sich eine flexible Isolatorschicht und eine leitfähige Lage einsparen.

In einer erfindugsgemäßen Ausgestaltung umfasst die Anzeigevorrichtung Steuerungs- und/oder Auswertemittel, die derart ausgebildet sind, dass durch ein Signal einer kapazitiven Auswertung des Schichtsystems, das durch ein Berühren oder nahezu Berühren herrührt, eine erste Aktion ausgeführt und durch ein Signal einer resistiven Auswertung, das von einer Druckbeaufschlagung stammt, eine zweite Aktion ausgeführt wird. Beispielsweise werden durch die Auswertung des kapazitiven Schichtsystems an den Stellen, an denen sich beispielsweise ein Finger einer Bedienperson befindet entsprechende Symbole hervorgehoben. Dabei kann es sich um eine dargestellte Taste handeln, die dann bei einem Signal aus der resistiv auswertbaren Schichtanordnung an entsprechender Stelle als gedrückt interpretiert wird.

Insgesamt ist eine enorme Vielfalt von Auswerte- und Ansteuermöglichkeiten durch die Kombination einer kapazitiv und resistiv auswertbaren Schichtanordnung möglich.

### Zeichnungen

Zwei Ausführungsbeispiele der Erfindung sind in den Zeichnungen dargestellt und werden unter Angabe weiterer Vorteile und Einzelheiten nachfolgend näher erläutert. Es zeigen
- Figur 1: in einer schematischen Schnittanordnung eine berührungssensitive Anzeigevorrichtung mit einer kapazitiven und resistiven Schichtanordnung und
- Figur 2: in einer zu Figur 1 entsprechenden Darstellung eine vereinfachte Ausführungsform einer berührungssensitiven Anzeigevorrichtung.

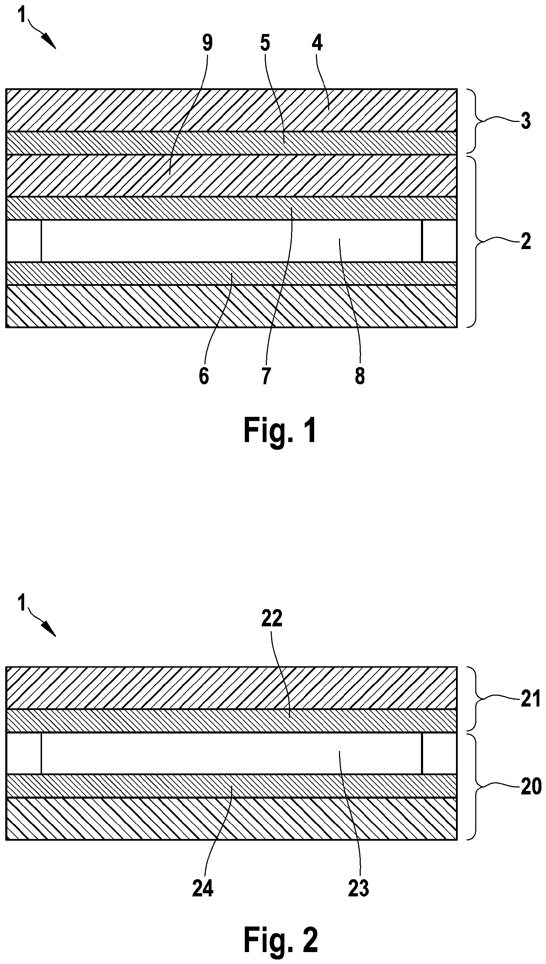

Die berührungssensitive Anzeigevorrichtung 1 nach Figur 1 umfasst eine resistive Schichtanordnung 2 sowie eine kapazitive Schichtanordnung 3, welche jeweils durch geschweifte Klammern im Gesamtschichtaufbau der Anzeigevorrichtung verdeutlicht sind. Der kapazitive Schichtaufbau besitzt eine flexible Isolatorschicht 4 und eine leitfähige als Kondensatorelektroden genutzte Schicht 5.

Im resistiven Schichtaufbau liegt zwischen zwei leitfähigen Schichten 6, 7 ein isolierender Zwischenraum 8. Die leitfähige Schicht 6 ist auf einer Isolatorschicht, vorzugsweise einer festen Isolatorschicht angeordnet, wogegen über der leitfähigen Schicht 7 eine flexible Isolatorschicht 9 entsprechend der flexiblen Isolatorschicht 4 vorgesehen ist.

Auf diese Weise kann eine Druckbeaufschlagung über den kapazitiven Schichtaufbau 3 auf den resistiv auswertbaren Schichtaufbau 2 weitergeleitet werden, in dem sich beide flexible Isolatorschichten zusammen mit den leitfähigen Schichten verformen, bis beispielsweise an einer Stelle die leitfähigen Schichten 6, 7 durch Verringerung des isolierenden Zwischenraums 8 zur Anlage kommen.

In Figur 2 ist eine vereinfachte Ausführungsform dargestellt. Dabei ist in einen resistiv auswertbaren Schichtaufbau 20 ein kapazitiv auswertbarer Schichtaufbau 21 integriert. Auf diese Weise lässt sich eine flexible Isolatorschicht mit leitfähiger Schicht einsparen. Hierzu ist es allerdings notwendig, dass eine leitfähige Schicht 22 für eine kapazitive Auswertung ausgebildet ist.

Durch das Einsparen einer flexiblen Schicht, kann der ganze Aufbau gegenüber Druck gegebenenfalls noch empfindlicher ausgestaltet werden. Denn eine Druckbeaufschlagung wirkt sich über nur eine flexible Schicht unmittelbar auf einen isolierenden Zwischenraum 23 zwischen der leitfähigen Schicht 22 und einer leitfähigen 24 aus, ohne dass eine darüber liegende flexible Schicht zuvor deformiert werden muss.

## Patentansprüche

1. Anzeigevorrichtung (1) mit berührungssensibler Oberfläche, die ein Schichtsystem (2, 3, 20, 21) zur Bestimmung der Position eines die Oberfläche der Anzeigevorrichtung (1) berührenden oder kurz vor der Berührung stehenden Objekts, zum Beispiel eines Fingers, umfasst, wobei das Schichtsystem (2, 3, 20, 21) sowohl eine kapazitive als auch resistive Auswertbarkeit erlaubt, wobei Steuerungs- und/oder Auswertemittel vorgesehen und derart ausgebildet sind, dass durch ein Signal einer kapazitiven Auswertung des Schichtsystems (2, 3, 20, 21) eine erste Aktion ausgeführt wird, wobei hierbei durch ein Signal einer kapazitiven Auswertung ein Bildinhalt an der Position des die Oberfläche der Anzeigevorrichtung (1) berührenden oder kurz vor der Berührung stehenden Objekts geändert wird, indem eine Taste hervorgehoben dargestellt wird, wobei durch ein Signal einer resistiven Auswertung eine zweite Aktion ausgeführt wird, und wobei hierbei durch ein Signal einer resistiven Auswertung bei einer Berührung an der Position eines die Oberfläche der Anzeigevorrichtung (1) berührenden Objekts ein Schaltvorgang eingeleitet wird.

2. Anzeigevorrichtung nach Anspruch 1, **dadurch gekennzeichnet, dass** eine kapazitiv auswertbare Schichtanordnung (3) über einer resistiv auswertbaren Schichtanordnung (2) liegt.

3. Anzeigevorrichtung nach einem der vorhergehenden Ansprüche, **dadurch gekennzeichnet, dass** die kapazitiv und resistiv auswertbare Schichtanordnung (2, 3) jeweils eine flexible Isolatorschicht (4, 9) aufweisen.

4. Anzeigevorrichtung nach einem der vorhergehenden Ansprüche, **dadurch gekennzeichnet, dass** die kapazitiv und resistiv auswertbare Schichtanordnung (20, 21) gemeinsam eine leitende Schicht (22) nutzen.

## Claims

1. Display device (1) with touch-sensitive surface which comprises a layer system (2, 3, 20, 21) for determining the position of an object, for example a finger, that is touching or just about to touch the surface of the display device (1), wherein the layer system (2, 3, 20, 21) allows both capacitive and resistive evaluability, wherein control and/or evaluation means are provided and configured in such a way that a first action is performed as a result of a signal of a capacitive evaluation of the layer system (2, 3, 20, 21), wherein in this case, as a result of a signal of a capacitive evaluation, an image content at the position of the object that is touching or just about to touch the surface of the display device (1) is changed by a key being represented in a highlighted manner, wherein a second action is performed as a result of a signal of a resistive evaluation, and wherein in this case, as a result of a signal of a resistive evaluation, a switching process is initiated upon touching at the position of an object that is touching the surface of the display device (1).

2. Display device according to Claim 1, **characterized in that** a capacitively evaluatable layer arrangement (3) lies above a resistively evaluatable layer arrangement (2).

3. Display device according to either of the preceding claims, **characterized in that** the capacitively and resistively evaluatable layer arrangements (2, 3) in each case have a flexible insulator layer (4, 9).

4. Display device according to any of the preceding claims, **characterized in that** the capacitively and resistively evaluatable layer arrangements (20, 21) jointly use a conductive layer (22).

## Revendications

1. Dispositif d'affichage (1) comportant une surface tactile qui comprend un système de couches (2, 3, 20, 21) permettant de déterminer la position d'un objet en contact avec la surface du dispositif d'affichage (1) ou présent peu de temps avant le contact, par exemple d'un doigt, dans lequel le système de couches (2, 3, 20, 21) permet à la fois une évaluation capacitive et résistive, dans lequel il est prévu des moyens de commande et/ou d'évaluation qui sont conçus de manière à ce qu'une première action soit effectuée au moyen d'un signal d'une évaluation capacitive du système de couches (2, 3, 20, 21), dans lequel un contenu d'image est ainsi modifié par un signal d'une évaluation capacitive à la position de l'objet touchant la surface du dispositif d'affichage (1) ou présent peut de temps avant le contact, en représentant une touche en surbrillance, dans lequel une deuxième action est réalisée par un signal d'une évaluation résistive et dans lequel un processus de commutation est déclenché par un signal d'une évaluation résistive lors d'un contact à la position d'un objet en contact avec la surface du dispositif d'affichage (1).

2. Dispositif d'affichage selon la revendication 1, **caractérisé en ce qu'**un agencement de couches (3) pouvant être évalué de manière capacitive est situé sur un agencement de couches (2) pouvant être évalué de manière résistive.

3. Dispositif d'affichage selon l'une quelconque des revendications précédentes, **caractérisé en ce que** les agencements de couches pouvant être évalués de manière capacitive et résistive (2, 3) présentent respectivement une couche d'isolant flexible (4, 9).

4. Dispositif d'affichage selon l'une quelconque des revendications précédentes, **caractérisé en ce que** les agencements de couches pouvant être évalués de manière capacitive et résistive (20, 21) utilisent en commun une couche conductrice (22).
